# EUROPÄISCHE PATENTANMELDUNG

(11) **EP 1 498 912 A2**
(43) Veröffentlichungstag der Anmeldung: **19.01.2005**
(21) Anmeldenummer: 04015829.7
(22) Anmeldetag: 06.07.2004
(51) Int. Cl.: H01F 7/18

(54) **Auslöseschaltung für ein elektromagnetisches Stellglied**

(30) Priorität: 16.07.2003 DE 10332250
(71) Anmelder: Erben Kammerer KG, 51469 Bergisch Gladbach (DE)
(72) Erfinder: Adams, Hans, 51063 Köln (DE)
(74) Vertreter: Selting, Günther, Dipl.-Ing.

(57) **Zusammenfassung**

Die Auslöseschaltung für ein Stellglied (10) enthält einen nahe dem Stellglied angeordneten Energiespeicher (11). Der Energiespeicher ist derart ausgebildet, dass er sich auf ein Auslösesignal hin unverzögert entlädt, wobei der Strom bzw. die Spannung der Entladung auf dasjenige Maß beschränkt ist, das erforderlich ist, um das Stellglied (10) zu betätigen. Damit ist ein schnelles Ansprechen des Stellgliedes gewährleistet, ohne dass ein Überschießen der Entladeenergie stattfindet.

## Beschreibung

Die Erfindung eine Auslöseschaltung für ein elektromagnetisches Stellglied, welches eine elektrische Zeitkonstante und eine Schaltschwelle hat, mit einem an eine Versorgungsspannung anschließbaren Energiespeicher, der über mindestens einen Schalter mit dem Stellglied verbindbar ist.

Auslöseschaltungen für elektromagnetische Stellglieder werden häufig in der Nähe explosionsgefährdeter Bereiche eingesetzt, beispielsweise in der chemischen Industrie. Ein typisches Anwendungsgebiet sind Stellglieder für Ventile, z.B. Linearaktuatoren für Absperrschieber. Diese Ventile dienen in Schutzsystemen dazu, Massen- und Volumenströme sehr schnell an- oder abzuschalten oder dazu geeignete Absperrorgane sehr schnell vorzusteuern und damit Schalthandlungen auszuführen. Die Betätigung elektromagnetischer Stellglieder erfordert es, für kurze Zeit sehr hohe Leistungen bereitzustellen. Wenn die für die Schalthandlung notwendige Energie durch den explosionsgefährdeten Bereich übertragen werden muss, müssen die betreffenden Leitungen explosionsgeschützt geführt werden. Dies verursacht einen erheblichen Aufwand. Bekannt ist es auch, in der Nähe des Stellgliedes einen Energiespeicher vorzusehen, wobei das Auslösesignal als relativ schwaches elektrisches Signal durch den explosionsgefährdeten Bereich zum Energiespeicher geführt wird. Die Energiespeicher sind in der Regel Akkumulatoren oder Kondensatorbatterien.

Stellglieder müssen häufig sehr schnell betätigt werden. Wenn zur Betätigung des Stellgliedes ein Energiespeicher entladen wird, ist damit häufig eine beträchtliche Verzögerung von mehreren Millisekunden verbunden. Zur Beschleunigung des Stellvorganges kann die Ladespannung des Energiespeichers erhöht werden. Dies erhöht jedoch in explosionsgefährdeter Umgebung die Explosionsgefahr. Außerdem besteht die Gefahr, dass der in einem Stellglied enthaltene Weicheisenkern durch eine zu hohe Spannung in die Sättigung gefahren wird. Permanentmagnete können zerstört werden, falls die Koerzitivfeldstärke überschritten wird.

Der Erfindung liegt die Aufgabe zugrunde, eine Auslöseschaltung für ein elektromagnetisches Stellglied zu schaffen, die kurze Reaktionszeiten hat und keine gefährlichen Situationen hervorruft.

Die erfindungsgemäße Auslöseschaltung weist die Merkmale des Patentanspruches 1 auf. Hiernach ist der Energiespeicher derart ausgebildet, dass er nach dem Verbinden mit dem Stellglied innerhalb einer Zeit, die kürzer ist als die Zeitkonstante des Stellgliedes, einen Strom oder eine Spannung vorbestimmter Größe, die nicht mehr als 20 % über der Schaltschwelle des Stellgliedes liegt, liefert. Der Energiespeicher bringt den Strom bzw. die Spannung zur Betätigung des Stellgliedes in kurzer Zeit auf die erforderliche Höhe, ohne dass ein wesentliches Überschwingen erfolgt. Der Energiespeicher wird während der Wartezeit aufgeladen und im aufgeladenen Zustand gehalten. Er baut den erforderlichen Strom mit hoher Anstiegsgeschwindigkeit auf. Die Entladung erfolgt also nicht nach einer e-Funktion, sondern durch Aufprägen eines Stromes oder einer Spannung mit vorbestimmtem zeitlichen Verlauf.

Für die Realisierung des Energiespeichers mit den geforderten Eigenschaften bestehen mehrere Möglichkeiten. Eine bevorzugte Möglichkeit sieht vor, dass der Energiespeicher aus einer LC-Kette mit zahlreichen Längsinduktivitäten und Querkondensatoren besteht. Eine solche LC-Kette, die an eine mittlere Ladespannung gelegt wird, wird ständig in geladenem Zustand gehalten und durch Betätigung des Schalters entladen. Beim Entladevorgang entladen sich sämtliche Kondensatoren gleichzeitig, wodurch praktisch unverzögert ein Strom einer vorbestimmten und gleichbleibenden Höhe in das Stellglied eingeprägt wird. Die LC-Kette erzeugt somit einen Stromimpuls von Rechteckform. Vorzugsweise haben die Kondensatoren gleiche Kapazitätswerte und zugehörigen Spulen gleiche Induktivitätswerte.

Eine andere Möglichkeit der Realisierung des Energiespeichers besteht in der Verwendung eines Spannungsvervielfachers mit mehreren Reihenschaltungen aus Dioden und Kondensatoren. Ein solcher Spannungsvervielfacher erzeugt einen Spannungsverlauf von der Form eines steilen und hohen Rechteckimpulses. Nach dem Abfall dieses Recheckimpulses geht der Verlauf in eine niedrigere Amplitude über.

Die Bemessung der LC-Kette oder des Spannungsvervielfachers ist so vorzunehmen, dass eine Anpassung an die elektrischen Größen des Stellgliedes erfolgt, das im Allgemeinen aus Kombination aus R und L angesehen werden kann.

Eine weitere Möglichkeit der Realisierung des Energiespeichers besteht darin, eine geregelte Strom- oder Spannungsquelle vorzusehen, deren Ausgangsgröße begrenzt ist. Die Strom- oder Spannungsquelle erzeugt einen konstanten Strom oder eine Spannung von vorgegebenem Verlauf, so dass die gewünschte Rechteckform des Betätigungssignals für das Stellglied durch elektronische Regelung erhalten werden kann.

Gemäß einer bevorzugten Ausgestaltung der Erfindung ist die Versorgungsspannung zur Erzeugung eines Auslösesignals zur Betätigung des mindestens einen Schalters umpolbar. Ein solches Umpolen ist durch eine entsprechende Diodenschaltung leicht detektierbar. Insbesondere erfordert die Detektion keine bestimmten Spannungspegel. Sie ist daher einfach und sicher durchführbar.

Eine bevorzugte Ausgestaltung der Erfindung sieht vor, dass das Stellglied in Reihe mit einem Ruhestromkreis liegt, welcher mindestens ein Ruhestromrelais enthält. Im Ruhezustand bewirkt der Energiespeicher das Fließen eines Ruhestromes. Das Ausbleiben des Ruhestroms wird erkannt und führt zur Einleitung spezieller Maßnahmen, wie den Schnellschluss eines Absperrschiebers zum Fernhalten gefährlicher Substanzen. Der Spannungspegel des elektrischen Energiespeichers, ab dem überhaupt ein Ruhestrom fließen soll, kann z.B. über eine Zenerdiode festgelegt werden. So kann sichergestellt werden, dass unterhalb eines bestimmten Spannungsniveaus immer eine "Störung" erkannt wird, so dass das Absperrorgan geschlossen wird und bleibt. Da Lade- und Ruhestrom über die gleichen Leitungen geführt werden, wird der Ausfall des Ruhestroms durch folgende Ereignisse veranlasst:
1. Ein Leitungsbruch einschließlich Ausfall der Stromversorgung am Eingang
2. Der Energiespeicher ist noch nicht geladen
3. Die Speicherschaltung ist defekt.

Die Erfindung betrifft ferner ein Verfahren zum Auslösen eines elektromagnetischen Stellgliedes. Dabei wird das Stellglied innerhalb einer Zeit, die kürzer ist als die Zeitkonstante des Stellglieds, mit einem Strom oder einer Spannung vorbestimmter Größe beaufschlagt, die nicht mehr als 20 % - vorzugsweise nicht mehr als 10 % - über der Schaltschwelle des Stellgliedes liegt. Dabei ist sichergestellt, dass weder weichmagnetische Bauelemente über die Sättigung gefahren werden noch die Koerzitivfeldstärke eingesetzter Permanentmagneten überschritten wird.

Im Folgenden werden unter Bezugnahme auf die Zeichnungen Ausführungsbeispiele der Erfindung näher erläutert. Die Zeichnungen und die detaillierte Beschreibung von Ausführungsbeispielen dient dem besseren Verständnis der Erfindung, schränkt jedoch den Schutzbereich nicht ein. Dieser wird vielmehr durch die Patentansprüche bestimmt.

Es zeigen:
- Fig. 1: ein Schaltbild einer ersten Ausführungsform der Auslöseschaltung,
- Fig. 2: den zeitlichen Verlauf des Treibersignals für das Stellglied,
- Fig. 3: eine modifizierte Ausführungsform des Energiespeichers als Spannungsvervielfacher, und
- Fig. 4: den Verlauf der Treiberspannung bei dem Ausführungsbeispiel von Figur 3.

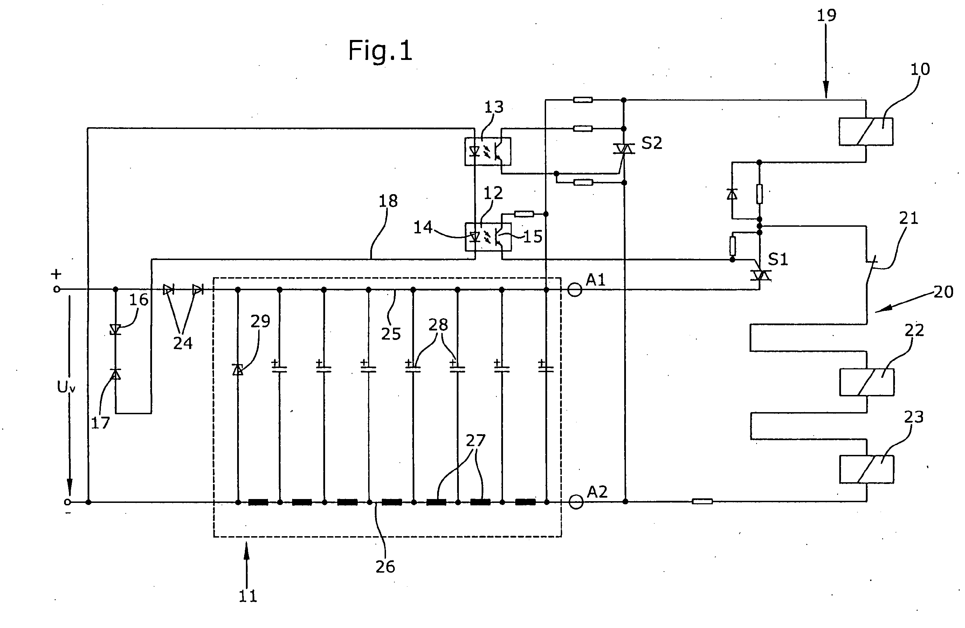

Die Auslöseschaltung nach Figur 1 wird mit einer Versorgungsspannung U_{V} versorgt, bei der es sich hier um eine Gleichspannung von beispielsweise 70 Volt handelt. Die Versorgungsspannung wird an einen nahe dem Stellglied 10 angeordneten Energiespeicher 11 gelegt. Das Stellglied 10 ist ein elektromagnetisches Stellglied, das dazu dient, eine Bewegung auszuführen. Beispielsweise betätigt das Stellglied 10 einen Absperrschieber, der eine Leitung, durch welche eine Substanz strömt, absperrt oder öffnet. Das Stellglied 10 ist beispielsweise eine Tauchspule. Es enthält einen Elektromagneten, der eine Induktivität und einen ohmschen Widerstand bildet. Das Stellglied hat eine Schaltschwelle, d.h. es muss ein bestimmter Strom oder eine bestimmte Spannung überschritten werden, um das Stellglied in Funktion zu setzen. Das Stellglied ist über einen ersten elektronischen Schalter S1 mit dem einen Pol A1 des Ausgangs des Energiespeichers 11 verbunden und über einen zweiten elektronischen Schalter S2 mit dem zweiten Pol A2 des Ausgangs. Der Energiespeicher 11 wird durch die elektronischen Schalter S1 und S2 zweipolig abgeschaltet. Die elektronischen Schalter S1 und S2 sind TRIACs. Der Schalter S1 wird durch einen Optokoppler 12 und der Schalter S2 wird durch einen Optokoppler 13 gesteuert. Jeder Optokoppler enthält in bekannter Weise eine Leuchtdiode 14 und einen Fototransistor 15, der das Licht der Leuchtdiode 14 empfängt. Dadurch wird eine galvanische Trennung zwischen Eingang und Ausgang des Optokopplers erreicht. Die beiden Optokoppler 12,13 sind in Reihe an die Versorgungsspannung U_{V} gelegt, wobei sich in der Reihenschaltung zusätzlich eine Zenerdiode 16 und eine Diode 17 befinden. Die Diode 17 ist mit ihrer Kathode dem positiven Pol der Versorgungsspannung U_{V} zugewandt. Der Auslösebefehl zur Betätigung des Stellgliedes 10 besteht darin, dass eine Polaritätsumkehr der Versorgungsspannung U_{V} erfolgt. Dann wird die Diode 17 durchlässig und durch die Reihenschaltung 18 fließt ein Strom, wodurch über die Optokoppler 12,13 Signale übertragen werden, durch die die Schalter S1 und S2 in den leitenden Zustand gesteuert werden. Der Polaritätswechsel der Versorgungsspannung wird mittels einer Polwendeschaltung durchgeführt. Alternativ zu einem Polwechsel kann das Auslösesignal auch dadurch erzeugt werden, dass eine Änderung der Phasenlage mehrerer Ausgangswechselspannungen zueinander erfolgt.

An den Stromkreis, der die Schalter S1 und S2 und das Stellglied 10 enthält, ist ein Ruhestromkreis 20 angeschlossen. Das eine Ende des Ruhestromkreises 20 ist an die Verbindung zwischen Stellglied 10 und Schalter S1 angeschlossen. Das andere Ende ist mit dem Pol A2 des Energiespeichers verbunden. Der Ruhestromkreis 20 enthält einen Sensor 21. Hierbei handelt es sich um einen Drucksensor, der bei Überschreiten oder Unterschreiten eines bestimmten Drucks den Ruhestromkreis unterbricht und dadurch eine Störung erkennbar macht. Der Ruhestromkreis enthält ferner ein Melderelais 22. Unterschreitet der Ruhestrom den Haltestrom dieses Relais, so wird die Polarität am Polaritätswechsler geändert. Damit wird eine Störung sicher gemeldet.

Schließlich enthält der Ruhestromkreis ein Ruhestromrelais 23. Dieses hält ein Ventil aktiv geschlossen. Unterschreitet der Ruhestrom den Haltestrom des Ruhestromrelais 23, so wird das Ventil geöffnet und fährt seinerseits das Absperrorgan schnell oder langsam zu. Hierdurch wird sichergestellt, dass das Absperrorgan zwangsweise geschlossen ist, so lange der elektrische Energiespeicher 11 nicht aufgeladen ist.

Mit dem Ruhestromkreis 20 wird erreicht, dass die Auslöseschaltung einschließlich des Energiespeichers 11 sich selbst überwacht und die angeschlossenen Geräte mit überwacht.

Wird ein Fehler detektiert, so wird der Schließvorgang des Absperrorgans eingeleitet, dieser Fehler angezeigt, und das Absperrorgan gegen Öffnen gesperrt.

Außerdem kann das Detektieren eines Fehlers einem zweiten Auslösesystem gemeldet werden, welches mit anderer Hilfsenergie, z.B. Druckluft, arbeitet, so dass das Absperrorgan mit der Hilfsenergie geschlossen wird. Der Ruhestromkreis wird mit der Ausgangsspannung des Energiespeichers 11 gespeist. Der Ruhestrom fließt nur, falls die Ausgangsspannung des Energiespeichers ungleich Null ist und der Ruhestromkreis nicht unterbrochen ist.

Dem Eingang des Energiespeichers 11 sind zwei Dioden 24 vorgeschaltet, die gegensinnig zu der Diode 17 gepolt sind. Der Energiespeicher 11 enthält eine Durchgangsleitung 25 und eine Leitung 26, die zahlreiche in Reihe geschaltete Induktivitäten 27 enthält. Zwischen jeweils zwei Induktivitäten ist die Leitung 26 mit der Durchgangsleitung 25 durch einen Kondensator 28 verbunden. Alle Induktivitäten 27 sind gleich und alle Kondensatoren 28 sind gleich. Die Induktivitäten 27 und die Kondensatoren 28 bilden eine LC-Kette mit Längsinduktivitäten und Querkondensatoren. Am Eingang des Energiespeichers 11 befindet sich eine Zenerdiode 29 zur Stabilisierung der Eingangsspannung. Die Pole A1 und A2 des Ausgangs des Energiespeichers werden von den Anschlüssen des letzten Kondensators 28 gebildet.

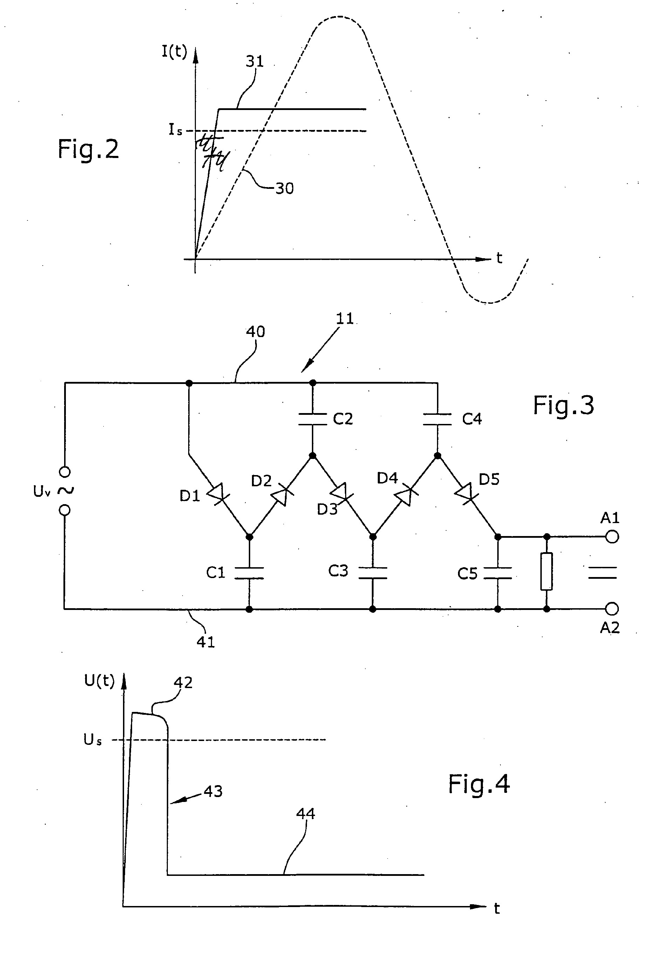

Der Energiespeicher 11 wird durch die Versorgungsspannung U_{V} permanent aufgeladen und im Ladezustand gehalten, solange die Schalter S1 und S2 im Sperrzustand sind. Werden diese Schalter in den leitenden Zustand gesteuert, so entsteht der in Figur 2 dargestellte Verlauf des Stromes I(t). I_{S} ist die Schaltschwelle des Stellgliedes 10, also derjenige Strom, den das Stellglied benötigt, um seine Funktion auszuüben. Man erkennt, dass der Strom I nach dem Auslösesignal sehr schnell auf den Endwert ansteigt und diesen eine Zeitlang beibehält. Der Energiespeicher entlädt sich somit ohne wesentliche Zeitverzögerung und mit einem Strom, der eine gewisse Zeitlang konstant bleibt.

Im Gegensatz hierzu ist in Figur 2 gestrichelt der Strom 30 dargestellt, der sich ergeben würde, wenn der Energiespeicher nur aus einem großen Kondensator bestehen würde. Da ein solcher Kondensator mit der Induktivität des Stellgliedes 10 einen Schwingkreis bildet, würde die Schaltschwelle wesentlich später erreicht. Der Entladestrom des Kondensators würde weit überschießen und den Magneten des Stellgliedes 10 weit über die Sättigung treiben.

Demgegenüber hat der Strom 31 einen schnellen Anstieg und eine gleichbleibende Stromstärke, die die Schaltschwelle I_{S} nicht wesentlich übersteigt.

Figur 3 zeigt ein anderes Ausführungsbeispiel eines Energiespeichers 11. Hierbei sind zwei Durchgangsleitungen 40,41 vorgesehen, die an eine Wechselspannung von beispielsweise 16 Volt gelegt sind. Die Durchgangsleitung 41 ist mit Kondensatoren C1,C3,C5 verbunden und die andere Durchgangsleitung 40 ist mit Kondensatoren C2,C4 verbunden. Die nicht mit einer Durchgangsleitung verbundenen Anschlüsse der Kondensatoren sind jeweils mit einer Diode verbunden. Die Dioden D1,D2,D3,D4 und D5 sind in Reihe geschaltet, wobei die Diode D1 mit der Durchgangsleitung 40 direkt verbunden ist. Bei einem Spannungsvervielfacher addieren sich die an den Kondensatoren C1-C5 entstehenden Gleichspannungen. Es handelt sich um eine Spannungsquelle, die eine hohe Spannung bereitstellt, welche höher ist als die Versorgungsspannung und nach vorgegebener Zeit auf einen niedrigeren Haltewert absinkt.

Dies ist in Figur 4 dargestellt, die den zeitlichen Verlauf der Spannung U (t) zeigt, die von dem Energiespeicher 11 nach Figur 3 bereitgestellt wird. Dabei ist die Schaltschwelle des Stellgliedes 10 mit U_{S} bezeichnet. Man erkennt, dass die Kurve 43 zunächst auf den Maximalwert 42 schnell ansteigt. Dieser ist ein Vielfaches der Versorgungsspannung Uv und er wird im Wesentlichen von C5 bestimmt. Danach fällt die Kurve 43 auf eine geringere Spannung 44 ab, die den stationären Zustand kennzeichnet und maßgeblich durch C1 bestimmt wird.

Unabhängig von der Art des jeweiligen Energiespeichers sollte die Ausgangsimpedanz des Energiespeichers an die Eingangsimpedanz des Stellgliedes 10 angepasst werden. Eine solche Anpassung ermöglicht es, die benötige Schaltenergie auf höchstens ein Zehntel der bisher eingesetzten Energie zu beschränken, ohne dass eine wesentliche Verschlechterung der elektrischen Auslösecharakteristik eintreten würde.

## Patentansprüche

1. Auslöseschaltung für ein elektromagnetisches Stellglied (10), welches eine elektrische Zeitkonstante und eine Schaltschwelle hat, mit einem an eine Versorgungsquelle anschließbaren Energiespeicher (11), der über mindestens einen Schalter (S1,S2) mit dem Stellglied (10) verbindbar ist,
**dadurch gekennzeichnet,**
**dass** der Energiespeicher derart ausgebildet ist, dass er nach dem Verbinden mit dem Stellglied (10) innerhalb einer Zeit, die kürzer ist als die Zeitkonstante des Stellgliedes, einen Strom oder eine Spannung vorbestimmter Größe, die über der Schaltschwelle (I_{S},U_{S}) liegt, liefert.

2. Auslöseschaltung nach Anspruch 1, **dadurch gekennzeichnet, dass** der Energiespeicher (11) aus einer LC-Kette mit zahlreichen Längsinduktivitäten (27) und Querkondensatoren (28) besteht.

3. Auslöseschaltung nach Anspruch 1 oder 2, **dadurch gekennzeichnet, dass** der Energiespeicher (11) aus einem Spannungsvervielfacher mit mehreren Reihenschaltungen aus Dioden (D1-D5) und Kondensatoren (C1-C5) besteht.

4. Auslöseschaltung nach Anspruch 1, **dadurch gekennzeichnet, dass** der Energiespeicher eine geregelte Strom- oder Spannungsquelle ist, deren Ausgangsgröße begrenzt ist.

5. Auslöseschaltung nach einem der Ansprüche 1-4, **dadurch gekennzeichnet, dass** der Schalter (S1,S2) ein elektronischer Schalter ist, der galvanisch getrennt gesteuert ist.

6. Auslöseschaltung nach einem der Ansprüche 1-5, **dadurch gekennzeichnet, dass** ein Schalter (S1,S2) in jeder der beiden Anschlussleitungen des Stellgliedes (10) enthalten ist.

7. Auslöseschaltung nach einem der Ansprüche 1-6, **dadurch gekennzeichnet, dass** die Versorgungsspannung (U_{V}) zur Erzeugung eines Auslösesignals zur Betätigung des mindestens einen Schalters (S1,S2) umpolbar ist.

8. Auslöseschaltung nach einem der Ansprüche 1-7, **dadurch gekennzeichnet, dass** das Stellglied (10) in Reihe mit einem Ruhestromkreis (20) liegt, welcher mindestens ein Ruhestromrelais (23) enthält.

9. Auslöseschaltung nach einem der Ansprüche 1-8, **dadurch gekennzeichnet, dass** der Ruhestromkreis (20) mindestens einen Sensor (21) als Unterbrecherschalter enthält.

10. Auslöseschaltung nach Anspruch 8 oder 9, **dadurch gekennzeichnet, dass** der Ruhestromkreis (20) von dem Ausgang des Energiespeichers (11) gespeist ist.

11. Verfahren zum Auslösen eines elektromagnetischen Stellgliedes (10), welches eine elektrische Zeitkonstante und eine Schaltschwelle hat, durch Entladen eines Energiespeichers (11) auf ein Auslösesignal hin, **dadurch gekennzeichnet, dass** das Stellglied (10) innerhalb einer Zeit, die kürzer ist als die Zeitkonstante, mit einem Strom oder einer Spannung vorbestimmter Größe beaufschlagt wird, die nicht mehr als 20 % über der Schaltschwelle liegt.
